Europäisches Patentamt

European Patent Office

Office européen des brevets

(11) Veröffentlichungsnummer: **0 413 272 A2**

## (12) EUROPÄISCHE PATENTANMELDUNG

(21) Anmeldenummer: 90115403.9

(22) Anmeldetag: **10.08.90**

(51) Int. Cl.5: **G01R 13/26**

(30) Priorität: **14.08.89 DE 3926827**

(43) Veröffentlichungstag der Anmeldung:
**20.02.91 Patentblatt 91/08**

(84) Benannte Vertragsstaaten:
**AT CH DE ES FR GB IT LI NL**

(71) Anmelder: **ASCENTRONIC GERÄTEBAU GMBH**
**Hans-Loher-Strasse 4**
**D-8399 Ruhstorf a.d. Rott(DE)**

(72) Erfinder: **Rösch, Wolfgang, Dipl.-Ing.**
**Hans-Loher-Strasse 4**
**D-8399 Ruhstorf a.d. Rott(DE)**

(74) Vertreter: **Klunker . Schmitt-Nilson . Hirsch**
**Winzererstrasse 106**
**D-8000 München 40(DE)**

(54) Verfahren, Vorrichtung und Tastkopf zur oszilloskopischen Messung eines elektrischen Dreiphasensystems.

(57) Um ein elektrisches Dreiphasensystem hinsichtlich der Amplitude seiner Ströme oder Spannungen und hinsichtlich der Phasenverschiebung zwischen Strömen und Spannungen mittels üblicher Oszilloskope messen zu können, sieht die Erfindung vor, das Dreiphasensystem in ein Zweiphasensystem umzuwandeln und dessen beide Phasen auf den Horizontal- bzw. den Vertikalablenkeingang des Oszilloskops zu geben, sowie im Fall der Messung der Stromphasen eine Spannungsphase und im Fall der Messung der Spannungsphasen eine Stromphase des Dreiphasensystems auf das Auftreten eines vorbestimmten Phasenwinkels zu detektieren und jedes Mal, wenn dieser Phasenwinkel detektiert wird, einen Markierungsimpuls zu erzeugen, der auf einen Helligkeits- oder Farbsteuerungseingangs des Oszilloskops gegeben wird. Dadurch wird, wenn die Amplituden der drei Phasen gleich groß sind, auf dem Oszilloskop ein Kreis dargestellt und auf dem Kreis eine Marke veränderter Helligkeit oder Farbe, wobei der Kreisradius der Amplitude und die Winkellage der Marke der Phasenverschiebung zwischen Spannung und Strom des Dreiphasensystems entspricht.

Figur 4

EP 0 413 272 A2

# VERFAHREN, VORRICHTUNG UND TASTKOPF ZUR OSZILLOSKOPISCHEN MESSUNG EINES ELEKTRISCHEN DREIPHASENSYSTEMS

Die Erfindung betrifft ein Verfahren, eine Vorrichtung und einen Tastkopf zur oszilloskopischen Messung der Strom- oder Spannungsphasen eines Dreiphasensystems.

Mit zwei gegeneinander phasenverschobenen Wechselspannungen gleicher Frequenz läßt sich im allgemeinen eine Ellipse auf einem Oszilloskopschirm darstellen. Beträgt die Phasenverschiebung der beiden Spannungen zueinander 90 Grad und ist die Amplitude beider Spannungen gleich groß, so wird ein Kreis abgebildet.

Dreiphasen-Drehstromsysteme weisen eine Verschiebung von Phase zu Phase von 120° auf. Die Spannungen oder Ströme eines solchen Dreiphasensystems zur oszilloskopischen Darstellung eines Kreises zu benutzen ist nicht ohne weiteres möglich. Denkbar und praktizierbar wäre die Verwendung einer Kathodenstrahlröhre mit drei Ablenkplattenpaaren oder entsprechenden Ablenkspulen zur Elektronenstrahlablenkung. Beide Lösungen sind aufwendig, weil sie von der standardmäßigen x-y-Darstellung abweichen. Es müßten für die Darstellung von Dreiphasensystemen spezielle Oszilloskope hergestellt werden. Hinzu kommt, daß diese Oszilloskope nicht ohne weiteres für die übliche x-y-Darstellung geeignet wären. Zur Messung von Zweiphasensystemen und von Dreiphasensystemen bräuchte man somit zwei verschiedene Oszilloskope.

Der Erfindung liegt daher die Aufgabe zugrunde, eine Methode zur oszilloskopischen Messung von Dreiphasensystemen mit herkömmlichen Oszilloskopen verfügbar zu machen.

Die Lösung dieser Aufgabe besteht darin,
- einerseits das Dreiphasensystem mit seinen drei um jeweils 120° versetzten Phasen in ein Zweiphasensystem mit zwei um 90° zueinander versetzten Phasen umzuwandeln und dieses resultierende Zweiphasensystem auf einem herkömmlichen Oszilloskop mit Horizontalablenkeinheit und mit Vertikalablenkeinheit darzustellen, also in der standardmäßigen x-y-Darstellung, und
- andererseits einen Phasenwinkeldetektor vorzusehen, der im Fall der oszilloskopischen Darstellung der Stromphasen eine der Spannungsphasen des Drei phasensystems und im Fall der oszilloskopischen Darstellung der Spannungsphasen eine der Stromphasen des Dreiphasensystems auf das Auftreten eines vorbestimmten Phasenwinkels hin überwacht und bei jeder Detektion dieses vorbestimmten Phasenwinkels die Erzeugung eines Markierungsimpulses auslöst, der auf den bei üblichen Oszilloskopen vorhandenen Helligkeitssteuerungseinang des Oszilloskops gegeben wird oder im Fall eines Oszilloskops mit Farbbildschirm auf einen Farbsteuereingang gegeben werden kann.

Werden beispielsweise die Stromphasen oszilloskopisch dargestellt, entsteht auf dem Oszilloskopschirm dann, wenn die drei Stromphasen gleiche Amplitude aufweisen, ein Kreis einer bestimmten Helligkeit und auf diesem Kreis eine punktförmige Marke mit einer anderen Helligkeit, vorzugsweise erhöhten Helligkeit. Der Radius des Kreises ist ein Maß für die Amplitude der Phasenströme des Dreiphasensystems. Die Winkellage der Marke auf dem Kreis ist ein Maß für die Phasenverschiebung zwischen den Stromphasen und den je zugehörigen Spannungsphasen des Dreiphasensystems.

Sind die Amplituden der drei Stromphasen des Dreiphasensystems nicht gleich, beispielsweise weil die einzelnen Phasen unterschiedlich belastet sind, wird auf dem Oszilloskopbildschirm anstelle eines Kreises eine Ellipse dargestellt. Die Winkellage und Form der Ellipse läßt auf die Amplitudenunterschiede der drei Stromphasen schließen. Abweichungen von der Kreisform bzw. Ellipsenform lassen auf Unregelmäßigkeiten wie Oberschwingungen und dergl. schließen.

Die erfindungsgemäße Methode läßt sich auch zum oszilloskopischen Messen von rotierenden elektrischen Maschinen mit Dreiphasensystem verwenden. Dabei werden die Markierungsimpulse mit Hilfe eines Drehimpulsgebers erzeugt, der immer dann einen Impuls abgibt, wenn ein rotierendes Teil, beispielsweise eine Welle, der Maschine einen bestimmten Drehwinkel durchläuft. Auch in diesem Fall werden auf dem Oszilloskopbildschirm bei gleichen Amplituden der drei Phasen ein Kreis und darauf eine Marke dargestellt. Die Marke wird rotieren, wenn die Maschine einen Schlupf aufweist. Der auf dem Oszilloskopbildschirm dargestellte Kreis, auf dem diese Marke liegt, wird eine Deformation aufweisen, wenn die Maschine eine nicht symmetrische Stromaufnahme bzw. Stromabgabe aufweist. Die Deformation des Kreises wird rotieren, wenn der Läufer der Maschine einen Schaden hat. Aus der Lage der Deformation zur Marke kann auf den Ort der Schadenstelle am Läufer geschlossen werden.

Lösungen der obengenannten Aufgabe sind in Form eines Verfahrens in Anspruch 1, in Form einer Meßanordnung in Anspruch 6 und in Form eines Tastkopfes zum Anschließen eines Meßobjekts an ein Oszilloskop in Anspruch 12 angegeben.

Vorteilhafte Weiterbildungen geben die je zugehörigen Unteransprüche an.

Zu der bei der erfindungsgemäßen Methode vorgesehenen Umwandlung von einem Dreiphasensystem in ein Zweiphasensystem kann eine hierzu bekannte Schaltung verwendet werden. Vorzugsweise wird eine Dreiphasen/Zweiphasen-Wandlerschaltung verwendet, die eine erste der drei Stromphasen des Dreiphasensystems um 180° phasenverschiebt, die phasenverschobene Stromphase vektormäßig, also nach Winkel und Betrag, zu einer zweiten der drei Stromphasen summiert, die der Summierung zugeführten Signale oder das aus der Summierung resultierende Signal zur Anpassung an die Amplituden der drei Phasen amplitudengemäß reduziert und das reduzierte Signal als eine und die dritte Phase des Dreiphasensystems als zweite Phase des Zweiphasensystems weitergibt.

Zur Phasenwinkeldetektion werden vorzugsweise Null-Durchgänge der Spannungsphase im Fall der oszilloskopischen Darstellung der Stromphasen bzw. der Stromphase im Fall der oszilloskopischen Darstellung der Spannungsphasen verwendet. In diesem Fall weist der Phasenwinkeldetektor vorzugsweise eine Rechteckformerschaltung auf, welche die zu detektierende Phasenwelle in eine Rechteckwelle umwandelt, und einen Impulsgeber, welcher beim Auftreten der ansteigenden und/oder abfallenden Flanken der Rechteckwelle jeweils einen Markierungsimpuls erzeugt.

Für den Fall der oszilloskopischen Messung einer rotierenden elektrischen Maschine wird dieser Phasenwinkeldetektor an den Ausgang des oben erwähnten Drehimpulsgebers angeschlossen.

Bei einer besonders bevorzugten Ausführungsform der Erfindung sind der Dreiphasen/Zweiphasen-Wandler und der Phasenwinkeldetektor in einem Tastkopf zusammengefaßt, der zwischen das Meßobjekt und das Oszilloskop geschaltet wird. Vorzugsweise weist der Tastkopf ein Tastkopfgehäuse auf, in dem sich der Dreiphasen/Zweiphasen-Wandler und der Phasenwinkeldetektor befinden, und aus dem Tastkopfgehäuse herausgeführte Kabel, die mit Eingangsanschlüssen zum Anschließen an das Meßobjekt bzw. mit Ausgangsanschlüssen zum Anschließen an das Oszilloskop abgeschlossen sind. Dabei sind die Ausgangsanschlüsse und die an Spannungsphasen anzuschließenden Eingangsanschlüsse vorzugsweise als Steckverbinder ausgebildet, während die an Stromphasen anzuschließenden Kabel vorzugsweise mit Stromwandlern abgeschlossen sind, welche die Ströme der einzelnen Stromphasen induktiv aufnehmen und in entsprechende Spannungen umwandeln.

Durch Verwendung eines erfindungsgemäßen Tastkopfes ist es auf besonders einfache Weise möglich, ein Meßobjekt mit Dreiphasensystem an ein herkömmliches Oszilloskop mit Standardmäßiger x-y-Ablenkung und -Darstellung anzuschließen.

Sollen Mehrphasensysteme mit mehr als drei Phasen auf einem herkömmlichen Oszilloskop dargestellt werden, wird die vektormäßige Addition nacheinander mehrfach durchgeführt, bis schließlich nur noch ein Zweiphasensystem übrigbleibt, entsprechend Anspruch 20.

Die Erfindung wird nun anhand von Ausführungsformen näher erläutert. In den zugehörigen Zeichnungen zeigen:

Fig. 1 eine graphische Darstellung der Erzeugung eines Zweiphasensystems aus einem Dreiphasensystem;

Fig. 2 die graphische Darstellung von Spannung und Strom einer Phase und der Erzeugung einer Marke bei einem Nulldurchgang der Spannung sowie die Lage der Marke auf dem Stromverlauf;

Fig. 3 eine Darstellung auf einem Oszilloskopbildschirm, wobei die Lage der Marke bei verschiedenen Strömen und verschiedenen Phasenwinkeln dargestellt ist;

Fig. 4 ein prinzipielles Blockschaltbild einer Ausführungsform einer erfindungsgemäßen Meßanordnung;

Fig. 5 die in Fig. 4 gezeigte Meßanordnung zur Messung einer rotierenden elektrischen Maschine;

Fig. 6 eine Meßanordnung zur Messung der Spannnungen eines Dreiphasensystems;

Fig. 7 eine Meßanordnung zur Messung der Ströme eines Dreiphasensystems;

Fig. 8 eine erste Ausführungsform eines erfindungsgemäßen Tastkopfes; und

Fig. 9 eine zweite Ausführungsform eines erfindungsgemäßen Tastkopfes.

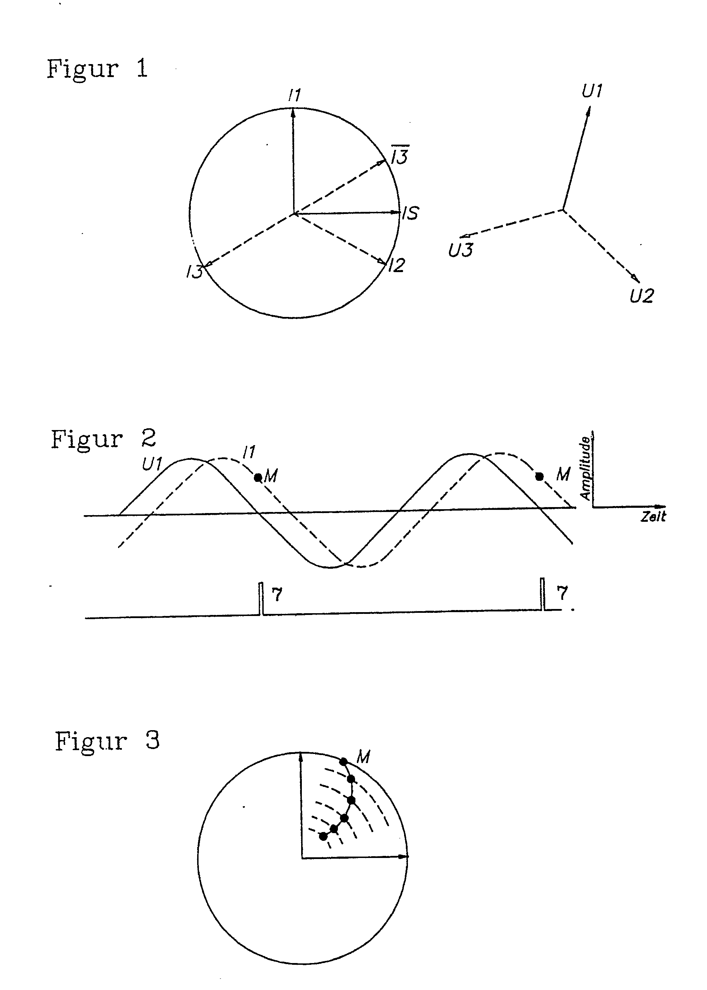

In Fig. 1 sind in Zeigerdarstellung die Ströme I1, I2 und I3 eines Dreiphasensystems gezeigt. Dabei haben die Ströme I1, I2 und I3 gleiche Amplituden und einen Phasenwinkelabstand von 120° voneinander. I2 bildet zusammen mit dem invertierten Wert von I3 einen nicht dargestellten Summenzeiger. Dieser ist zur Anpassung an die Amplituden der drei Ströme I1, I2 und I3 herabgeteilt. Der herabgeteilte Summenzeiger ist als IS dargestellt. IS bildet zusammen mit I1 ein Zweiphasensystem mit 90° zueinander versetzten Phasen. Gibt man diese Spannungen auf die x- und y-Eingänge oder Horizontalablenkungs- und Vertikalablenkungs-Eingänge eines Oszilloskops, so wird unter der Voraussetzung, daß sinusförmige Meßgrößen vorliegen, ein Kreis dargestellt. Der Durchmesser des Kreises entspricht der Amplitude der Ströme.

Sind die Ströme unsymmetrisch, weicht die Darstellung auf dem Oszilloskopbildschirm von einer Kreisform ab und nimmt die Gestalt einer Ellipse ab. Aus der Lage der Ellipse kann auf die Unsymmetrie geschlossen werden.

Sind die Ströme nicht sinusförmig, weicht die Darstellung auf dem Oszilloskopschirm von der Kreisform ab. Dies ist vor allem bei Stromrichtern der Fall. Aus der Regelmäßigkeit der Abbildung kann auch hier auf eine Symmetrie oder auf Abweichungen von der Symmetrie geschlossen werden.

Fig. 1 enthält außerdem eine Zeigerdarstellung des Dreiphasen-Spannungssystems. Dieses Spannungs-Dreiphasensystem ist in der Phasenlage zum Strom-Dreiphasensystem gedreht gezeigt. Wenn man beispielsweise zur Erzeugung der Marke auf dem Oszilloskopbildschirm den Spannungszeiger U1 heranzieht und in Beziehung zu dem Stromzeiger I1 bringt, wird die Lage der Marke auf der Oszilloskopdarstellung festgelegt.

In Fig. 2 sind die Spannung U1 und der Strom I1 gezeigt. Der Strom I1 eilt hier der Spannung U1 nach. Beim Nulldurchgang in Richtung zur negativen Halbwelle des Verlaufs der Spannung U1 wird jeweils ein Markierimpuls 7 erzeugt, der beispielsweise die Helligkeit der Darstellung auf der Oszilloskopbildröhre beeinflußt oder die Farbe der Darstellung im Fall eines Oszilloskops mit farbiger Bildröhre.

In Fig. 3 sind Beispiele für unterschiedliche Lagen der Marke bei unterschiedlichen Stromamplituden und unterschiedlichen Phasenverschiebungen zwischen Strom und Spannung dargestellt. Dabei ist der Radius des Kreises ein Maß für die Stromamplitude und die Winkellage der Marke M auf dem Kreis ein Maß für die Phasenverschiebung zwischen Strom und Spannung.

Fallen die Nulldurchgänge von Strom und Spannng zeitlich zusammen, wie es bei rein ohmscher Last der Fall ist, wird die Marke M in einer bestimmten Winkellage auf dem Kreis geschrieben. Besteht hingegen zwischen Strom und Spannung eine Phasenverschiebung, wird die Marke in einer anderen Winkellage auf dem Kreis dargestellt, wobei angenommen wird, daß sich die Stromamplitude und damit der Kreisradius nicht geändert haben. Bildet man gedachte Linien zwischen dem Kreismittelpunkt und einerseits der Marke bei ohmscher Last und andererseits der Marke bei einer Phasenverschie bung zwischen Storm und Spannung, entspricht der Winkel zwischen diesen beiden gedachten Linien exakt dem Phasenverschiebungswinkel.

Man kann auf dem Oszilloskopbildschirm eine drehbare Skala mit radial verlaufenden Linien und einer Winkelgradeinteilung anordnen, deren Nullwinkel-Linie zunächst bei ohmscher Last mit der dann erzeugten Marke M zur Deckung gebracht wird und an der nach diesem Eichvorgang die Phasenverschiebungswinkel mit Hilfe der jeweils erzeugten Marken M abgelesen werden können.

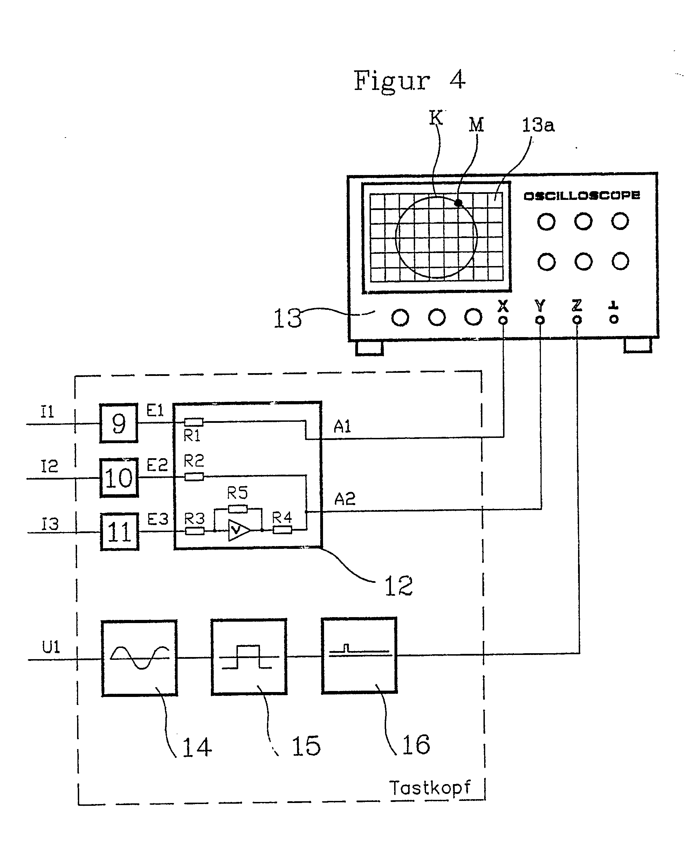

Fig. 4 zeigt ein Beispiel einer erfindungsgemäßen Meßanordnung zur Oszilloskopdarstellung der Ströme I1, I2 und I3 eines Dreiphasensystems. Dabei werden die Ströme I1, I2 und I3 mittels Stromwandlern 9, 10 bzw. 11 aufgenommen und in entsprechende Spannungen umgesetzt, die einem Dreiphasen/Zweiphasen-Wandler 12 zugeführt werden. Der Dreiphasen/Zweiphasen-Wandler 12 weist drei Eingänge E1, E2 und E3 auf, die an die Stromwandler 9, 10 bzw. 11 angeschlossen sind, und zwei Ausgänge A1 und A2, die an den Horizontal-Ablenkeingang X bzw. den Vertikalablenkeingang Y eines Oszilloskops 13 angeschlossen sind. Der Ausgang A1 ist mit dem Eingang E1 über einen Widerstand R1 verbunden. Der Ausgang A2 ist mit dem Eingang E2 über einen Widerstand R2 verbunden. Der Ausgangsanschluß A2 ist außerdem mit dem Eingangsanschluß E 3 über eine Reihenschaltung aus einem Widerstand R3, einem Verstärker V und einem Widerstand R4 verbunden, wobei zum Verstärker V ein Widerstand R5 parallel geschaltet ist.

Eine Spannungsphase des Dreiphasensystems, beispielsweise die Spannung U1, ist auf eine Eingangsstufe 14, beispielsweise eine Verstärkerstufe, geführt. Dieser nachgeschaltet ist ein Rechteckformer 15, der aus der Sinuswelle der Spannung U1 eine entsprechende Rechteckwelle erzeugt, deren Anstiegs- und Abfallflanken an den Nulldurchgangsstellen der Sinuswelle liegen. Der Rechteckformer 15 steuert einen Impulsgenerator 16, der bei jeder Anstiegsflanke der Rechteckwellenform einen Markierungsimpuls abgibt. Bei dem in Fig. 4 dargestellten Ausführungsbeispiel tritt der Markierungsimpuls immer dann auf, wenn die Sinuswelle der Spannung U1 beim Wechsel von positiver zu negativer Halbwelle einen Nulldurchgang aufweist. Die Markierungsimpulse werden auf einen Helligkeitssteuereingang Z des Oszilloskops 13 gegeben.

Auf einem Bildschirm 13a des Oszilloskops 13 wird mit Hilfe dieser Meßanordnung ein Kreis K abgebildet, entsprechend Fig. 3. Immer dann, wenn der Markierimpuls erzeugt wird, erfolgt die Kreisdarstellung mit erhöhter Helligkeit, so daß auf dem Oszilloskopbildschirm 13a ein Kreis mit einer Marke M erhöhter Helligkeit auf dem Kreisumfang erzeugt wird.

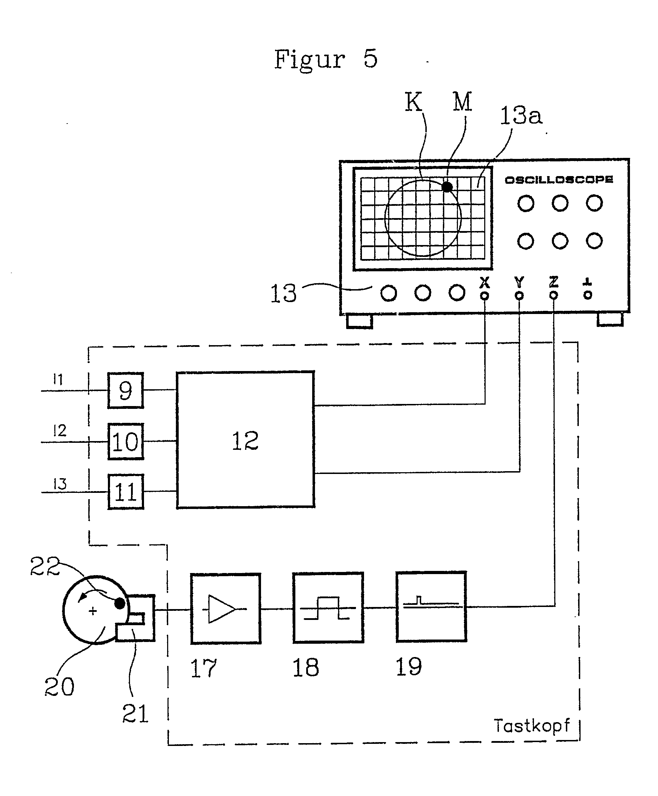

Fig. 5 zeigt eine Meßanordnung, die mit der in Fig. 4 gezeigten Meßanordnung weitgehend übereinstimmt. Eine Abweichung besteht darin, daß bei der Meßanordnung gemäß Fig. 5 die dort durch einen Verstärker 17 gebildete Eingangsstufe an den Ausgang eines Drehimpulsgebers 21 angeschlossen ist. Dieser wirkt mit einer markierten Stelle 22 auf einem rotierenden Teil 20 zusammen. Das rotierende Teil 20 gehört zu einer nicht dargestellten rotierenden elektrischen Maschine, beispielsweise einem elektrischen Motor, der aus dem Dreiphasensystem gespeist wird, oder einem elektrischen Generator, der in das Dreiphasensystem einspeist.

Bei dem Drehimpulsgeber kann es sich um eine der bekannten Konstruktionen handeln, beispielsweise einen induktiv, einen optisch oder einen durch mechanische Auslösung wirkenden Drehimpulsgeber. Das Ausgangssignal des Verstärkers 17 wird wie bei der Ausführungsform nach Fig. 4 auf einen Rechteckformer 18 gegeben, dem ein Impulsgeber 19 nachgeschaltet ist, dessen Ausgang mit dem Helligkeitssteuereingang Z des Oszilloskops 13 verbunden ist.

Auf dem Kreis K, der auf dem Oszilloskopbildschirm 13a dargestellt wird, erscheint eine Marke M in einer Winkelposition, die der Winkelposition der markierten Stelle 22 auf dem rotierenden Teil 20 entspricht.

Handelt es sich bei dem Meßobjekt um einen Elektromotor, der einen Schlupf aufweist, rotiert die Marke M auf dem Kreis K. Wenn der zu messende Motor oder Generator eine nicht symmetrische Stromaufnahme bzw. Stromabgabe aufweist, tritt eine Deformation des Kreises auf. Die Deformation des Kreises K rotiert wie die Marke M, wenn der Läufer des Motors bzw. Generators einen Schaden hat. Aus der Lage der Deformation zur Marke M kann auf den Ort der Schadensstelle am Läufer geschlossen werden.

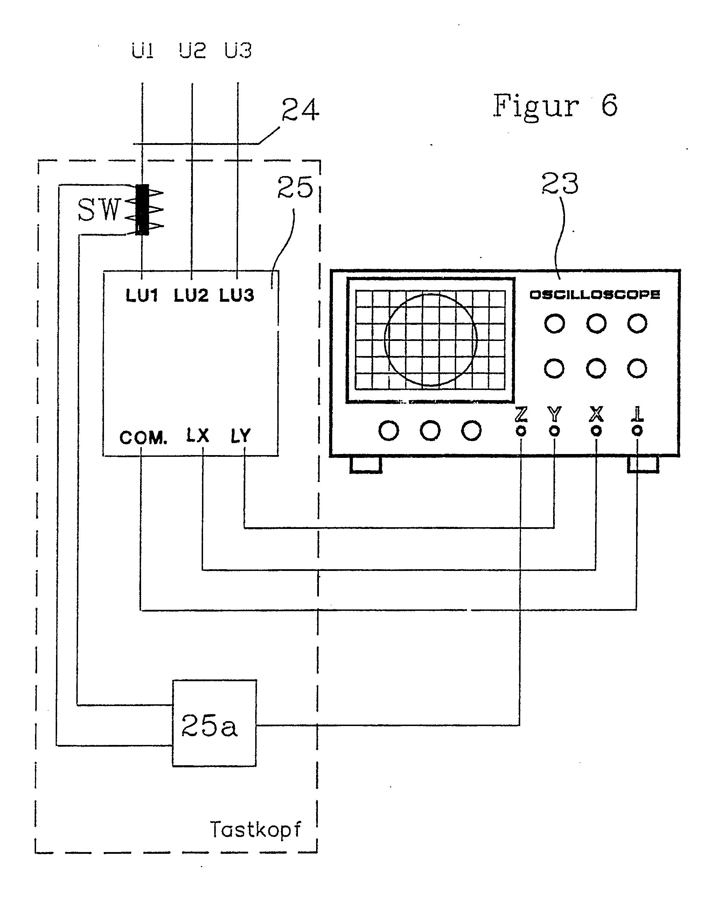

Fig. 6 zeigt eine Meßanordnung zur Messung der drei Spannungen U1, U2 und U3 eines Dreiphasensystems 24. Einem Dreiphasen/Zweiphasen-Wandler 25 werden über Eingänge LU1, LU2 und LU3 die drei Spannungen U1, U2 bzw. U3 zugeführt. An Ausgängen LX und LY des Dreiphasen/Zweiphasen-Wandlers 25 stehen die beiden Spannungen des Zweiphasensystems zur Verfügung, die den Ablenkeingängen X bzw. Y eines Oszilloskops 23 zugeführt werden. Ein Stromwandler SW erzeugt für einen Phasenwinkeldetektor 25a eine Eingangsspannung, die dem Strom I1 des Dreiphasensystems entspricht. Wie im Fall der zuvor beschriebenen Meßanordnungen erzeugt der Phasenwinkeldetektor 25a Markierungsimpulse bei den Nulldurchgängen, die bei den Übergängen von positiven zu negativen Halbwellen auftreten.

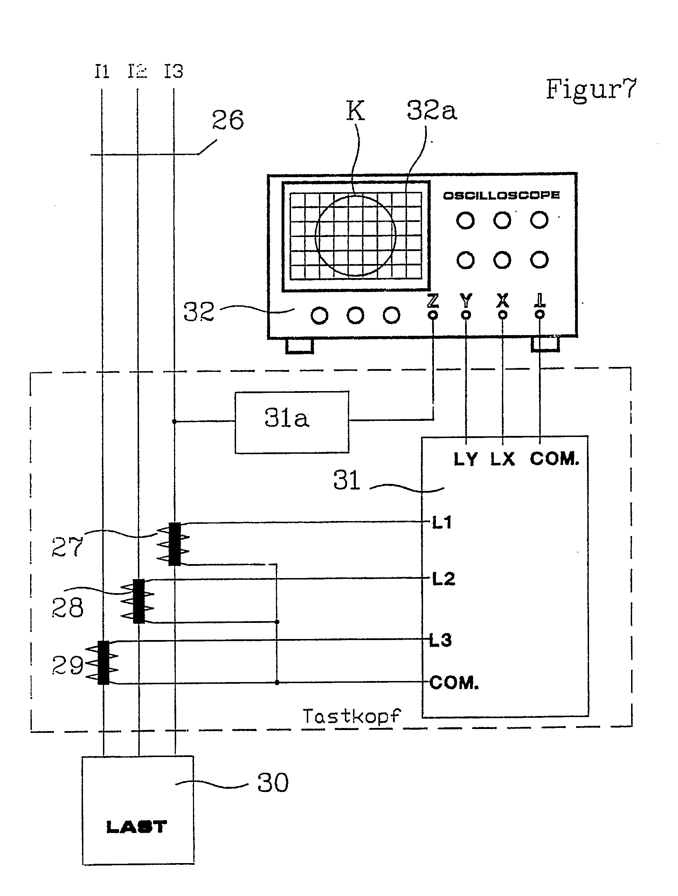

Fig. 7 zeigt eine Meßanordnung, mittels welcher die Ströme I1, I2 und I3 eines Dreiphasensystems 26 gemessen werden. Hierfür werden Stromwandler 27, 28 und 29 verwendet, die den Eingängen L1, L2 bzw. L3 eines Dreiphasen/Zweiphasen-Wandlers 31 Spannungen zuführen, die den Strömen I3, I2 bzw. I1 entsprechen. Die an den Ausgängen LX und LY auftretenden beiden Phasen des Zweiphasensystems werden wieder auf die Ablenkeingänge X bzw. Y gegeben. Mit Hilfe eines Phasendetektors 31a werden vorbestimmte Phasenwinkel, vorzugsweise wieder Nulldurchgänge, der Spannung U3 detektiert und entsprechende Markierungsimpulse auf den Helligkeitssteuereingang Z des Oszilloskops 32 gegeben. Zwischen dem Strom I3 und der Spannung U3 des Dreiphasensystems 26 tritt ein Phasenwinkel auf, der von einer Last 30 des Dreiphasensystems 26 abhängt.

Bei besonders bevorzugten Ausführungsformen der Erfindung sind der Dreiphasen/Zweiphasen-Wandler und der Phasendetektor in einem Tastkopfgehäuse eines Tastkopfes untergebracht, der über eingangs- und ausgangsseitige Kabel direkt an das Meßobjekt bzw. das Oszilloskop anschließbar ist.

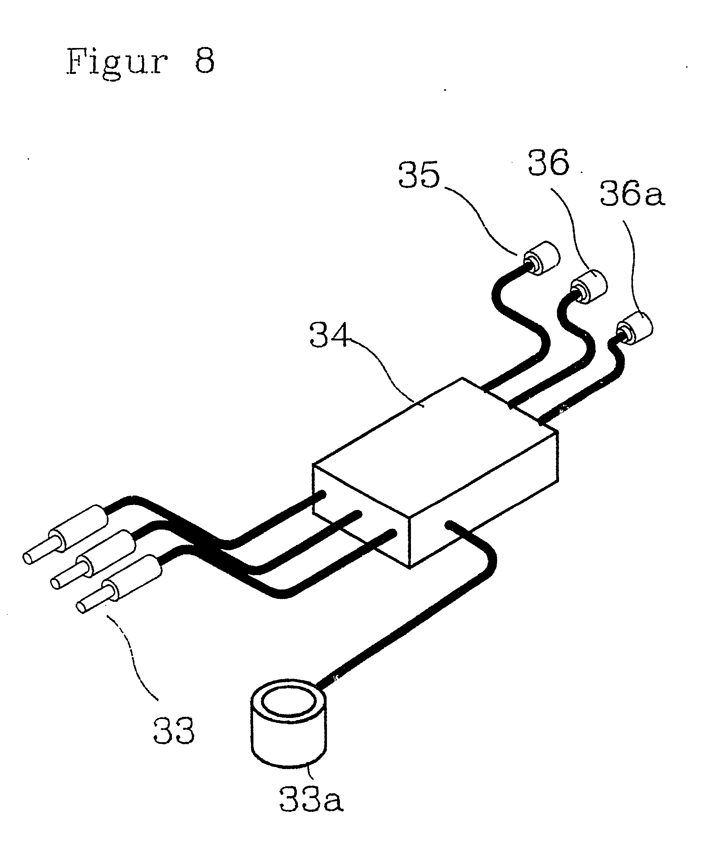

Fig. 8 zeigt einen solchen Tastkopf zur Messung der Spannungen eines Dreiphasensystems mit Hilfe eines Oszilloskops. Drei der eingangsseitigen Kabel sind mit je einem Steckverbinder 33 abgeschlossen, mit welchem sie an eine Spannungsphase des zu messenden Dreiphasensystems anschließbar sind. Ein viertes eingangsseitiges Kabel ist mit einem Stromwandler 33a abgeschlossen, mit dem einer der drei Ströme des Dreiphasensystems gemessen und eine entsprechende Spannung dem in einem Tastkopfgehäuse 34 untergebrachten Phasenwinkeldetektor zugeführt wird. Die drei ausgangsseitigen Kabel des Tastkopfes sind mit Steckverbindern 35, 36 bzw. 36a abgeschlossen, mittels welchen diese Kabel an die Ablenkeingänge X und Y und an den Helligkeitssteuereingang Z anschließbar sind.

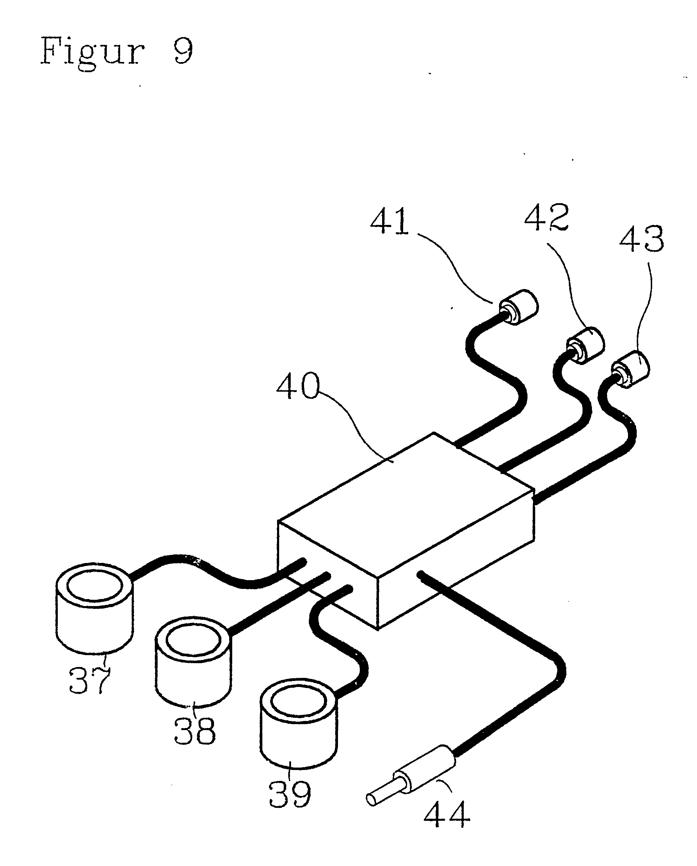

Fig. 9 zeigt einen Tastkopf zur Messung der Ströme eines Dreiphasensystems mit Hilfe eines Oszilloskops. In einem Tastkopfgehäuse 40 dieses Tastkopfes sind wieder ein Dreiphasen/Zweiphasen-Wandler und ein Phasenwinkeldetektor untergebracht. Damit werden einerseits die mit Hilfe von Stromwandlern 37, 38 und 39 erfaßten drei Ströme des zu messenden Dreiphasensystems in ein Zweiphasen-Spannungssystem umgesetzt und wird andererseits die mit Hilfe einer Spannungsmeßleitung 44 erfaßte Spannung einer Phase des Dreiphasensystems verwendet, um Markierungsimpulse zu erzeugen. Die beiden Spannungen des Zeiphasensystems und die Markierungsimpulse stehen dann an Steckverbindern 41, 42 und 43 zur Verfügung, mit denen Ausgangskabel dieses Tastkopfes abgeschlossen sind.

**Ansprüche**

1. Verfahren zur oszilloskopischen Messung der Stromphasen eines Dreiphasensystems mittels eines Oszilloskopes mit einem Horizontalablenkeingang (X), einem Vertikalablenkeingang (Y) und einem Helligkeits- oder Farbsteuerungseingang (Z), bei dem die drei Stromphasen des Dreiphasensystems in zwei Stromphasen eines Zweiphasensystems umgewandelt werden, von denen eine auf den Horizontalablenkeingang (X) und die andere auf den Vertikalablenkeinang (Y) geführt wird,

und bei dem das Auftreten eines vorbestimmten Phasenwinkels bei einer der drei Spannungsphasen des Dreiphasensystems detektiert und zum Detektionszeitpunkt jeweils ein Markierungsimpuls (M) erzeugt und auf den Helligkeits- bzw. Farbsteuerungseingang (Z) gegeben wird,

wodurch auf dem Oszilloskopschirm (13a; 32a) ein Kreis (K) einer ersten Helligkeit bzw. Farbe mit einem den Stromamplituden des Dreiphasensystems entsprechenden Radius und eine auf dem Kreis (K) liegende Marke (M) einer von der ersten Helligkeit bzw. Farbe verschiedenen zweiten Helligkeit bzw. Farbe, deren Winkellage auf dem Kreis (K) ein Maß für die Phasenverschiebung zwischen den Stromphasen und den Spannungsphasen des Dreiphasensystems ist, erzeugt werden.

2. Verfahren nach Anspruch 1, dadurch gekennzeichnet, daß Nulldurchgänge der zu detektierenden Spannungsphase des Dreiphasensystems detektiert werden.

3. Verfahren nach Anspruch 1 oder 2, dadurch gekennzeichnet, daß eine erste der drei Stromphasen (I1, I2, I3) des Dreiphasensystems um 180° phasenverschoben wird,

daß die phasenverschobene Stromphase und eine zweite der drei Stromphasen (I1, I2, I3) vektormäßig summiert werden,

daß die zu summierenden Signale oder das Summensignal zur Anpassung an die Stromamplituden des Dreiphasensystems betragsmäßig reduziert wird,

und daß das resultierende Signal auf den einen Ablenkeingang und die dritte Stromphase auf den anderen Ablenkeingang des Oszilloskops (13a; 32a) gegeben werden.

4. Verfahren nach mindestens einem der Ansprüche 1 bis 3, dadurch gekennzeichnet, daß anstelle der Stromphasen (I1, I2, I3) die Spannungsphasen (U1, U2, U3) des Dreiphasensystems in ein Zweiphasensystem umgewandelt werden und ein vorbestimmter Phasenwinkel einer Stromphase des Dreiphasensystems detektiert wird.

5. Verfahren zur oszilloskopischen Messung rotierender elektrischer Maschinen mit Dreiphasensystem nach mindestens einem der Ansprüche 1 bis 4 mit der Maßgabe, daß anstelle der Detektion eines vorbestimmten Phasenwinkels bei einer der drei Spannungs- bzw. Stromphasen das Auftreten eines vorbestimmten Drehwinkels eines rotierenden Teils der Maschine detektiert wird.

6. Meßanordnung zur Messung der Stromphasen eines Dreiphasensystems,

mit einem Oszilloskop (13; 32), das einen Horizontalablenkungseingang (X), einen Vertikalablenkungseingang (Y) und einen Helligkeits- oder Farbsteuerungseingang (Z) aufweist,

mit einer Dreiphasen/Zweiphasen-Wandlerschaltung (12; 31), deren Zweiphasen-Ausgänge (A1, A2; LX, LY) mit dem Horizontalablenkeinang (X) bzw. dem Vertikalablenkeingang (Y) gekoppelt sind,

mit einem Phasenwinkeldetektor (14, 15, 16; 31a), dem eine der drei Spannungsphasen des Dreiphasensystems zugeführt wird und der das Auftreten eines vorbestimmten Phasenwinkels bei dieser Spannungsphase detektiert und bei der Detektion dieses Phasenwinkels jeweils einen Markierungsimpuls (M) abgibt, der dem Helligkeits-bzw. Farbsteuerungseinang (Z) zugeführt wird.

7. Meßanordnung nach Anspruch 6, dadurch gekennzeichnet, daß der Phasenwinkeldetektor (14, 15, 16; 31a) Nulldurchgänge der ihm zugeführten Spannungsphase detektiert.

8. Meßanordnung nach Anspruch 6 oder 7, dadurch gekennzeichnet, daß der Dreiphasen/Zweiphasen-Wandler (12; 31) aufweist:
- einen 180°-Phasenschieber, dem eine erste Stromphase des Dreiphasensystems zugeführt wird,
- eine vektormäßig addierende Summiereinrichtung, der über einen ersten Eingang eine zweite Stromphase des Dreiphasensystems zugeführt wird und die über einen zweiten Eingang mit dem Ausgang des 180°-Phasenschiebers verbunden ist,
- eine Amplitudenreduzierschaltung zur betragsmäßigen Reduzierung der zu summierenden Signale oder des Summensignals zur Anpassung an die Amplitudenwerte der Stromphasen des Dreiphasensystems,

und daß der Ausgang der Summierschaltung mit dem einen Ablenkeingang (Y) gekoppelt ist und die dritte Stromphase des Dreiphasensystems auf den anderen Ablenkeingang (X) geführt ist.

9. Meßanordnung nach Anspruch 7 oder 8, dadurch gekennzeichnet, daß der Phasenwinkeldetektor (14, 15, 16; 31a) aufweist:
- einen Rechteckformer (15) zur Umformung des Wellenverlaufs der zu detektierenden Spannungsphase in eine Rechteckwelle
- und einen Impulsgenerator (16), der mit dem Ausgang des Rechteckformers (15) verbunden ist und beim Auftreten der Anstiegs- und/oder Abfallflanken der Rechteckwelle jeweils einen Markierungsimpuls erzeugt, der dem Helligkeits- bzw. Farbsteuerungseingang (Z) zugeführt wird.

10. Meßanordnung nach mindestens einem der Ansprüche 6 bis 9, dadurch gekennzeichnet, daß dem Dreiphasen/Zweiphasen-Wandler (25) anstelle der Stromphasen (I1, I2, I3) die Spannungsphasen (U1, U2, U3) des Dreiphasensystems (24) und dem Phasendetektor (25a) anstelle einer Spannungsphase eine Stromphase des Dreiphasensystems (24) zugeführt wird.

11. Meßanordnung zur oszilloskopischen Messung rotierender elektrischer Maschinen mit Dreiphasensystem nach mindestens einem der Ansprüche 6 bis 10 mit der Maßgabe, daß der Phasenwinkeldetektor (17, 18, 19) nicht mit einer der drei Spannungs- bzw. Stromphasen verbunden ist sondern mit einem mit einem rotierenden Teil (20) der Maschine zusammenwirkenden Drehimpulsgeber (21, 22).

12. Tastkopf zum Anschließen eines oszilloskopisch zu messenden elektrischen Dreiphasensystems (I1, I2, I3; 26) an ein

Oszilloskop (13; 32) mit einem Horizontalablenkeingang (X), einem Vertikalablenkeingang (Y) und einem Helligkeits- oder Farbsteuerungseingang (Z),

- mit vier Eingangsanschlüssen (37, 38, 39, 44) zum Anschluß an die drei Stromphasen und eine der drei Spannungsphasen des Dreiphasensystems,

- mit drei Ausgangsanschlussen (41, 42, 43) zum Anschluß an den Horizontalablenkeingang (X), den Vertikalablenkeingang (Y) und den Helligkeits- bzw. Farbsteuerungseinang des Oszilloskops (13; 32),

- mit einem Dreiphasen/Zweiphasen-Wandler (12; 31), der eingangsseitig mit den drei Stromphasen-Eingangsanschlüssen (37, 38, 39) und ausgangsseitig mit den zwei mit dem Horizontal- bzw. dem Vertikalablenkeingang (X, Y) verbindbaren Ausgangsanschlüssen (42, 43) verbunden ist,

- und mi einem Phasendetektor (14, 15, 16; 31a), der zwischen den Spannungsphasen-Eingangsanschluß (44) und den mit dem Helligkeits- bzw. Farbsteuerungseingang (Z) verbindbaren Ausgangsanschluß (41) geschaltet ist und das Auftreten eines vorbestimmten Phasenwinkels bei der auf den Spannungsphasen-Eingangsanschluß (44) geführten Spannungsphase detektiert und bei derartiger Detektion an seinem Ausgang (41) einen Markierungsimpuls abgibt.

13. Tastkopf nach Anspruch 12, dadurch gekennzeichnet, daß der Dreiphasen/Zweiphasen-Wandler aufweist:

- einen mit einem ersten der drei Stromphasen-Eingangsanschlüsse (37, 38, 39) verbundenen 180°-Phasenschieber,

- eine vektormäßig addierende Summierschaltung, die mit einem Eingang an einen zweiten der drei Stromphaseneingangsanschlüsse (37, 38, 39) und mit einem zweiten Eingang an den Ausgang des 180°-Phasenschiebers angeschlossen ist,

- und eine Amplitudenreduzierschaltung zur betragsmäßigen Reduzierung der zu summierenden Signale oder des Summensignals zur Anpassung an die Amplitudenwerte der Stromphasen des Dreiphasensystems,

- wobei der Ausgang der Summierschaltung mit einem der beiden mit dem Horizontalablenkeingang (X) bzw. dem Vertikalablenkeingang (Y) verbindbaren Ausgangsanschlüsse (42, 43) und der dritte der drei Stromphasen-Eingangsanschlüsse (37, 38, 39) mit dem anderen der beiden mit dem Horizontalablenkeingang (X) bzw. dem Vertikalablenkeingang (Y) verbindbaren Ausgangsanschlüsse (42, 43) gekoppelt ist.

14. Tastkopf nach Anspruch 12 oder 13, dadurch gekennzeichnet, daß der Phasendetektor aufweist:
- einen Rechteckformer (15) zur Umformung des Wellenverlaufs der dem Phasenwinkeldetektor zugeführten Spannungsphase in einer Rechteckwelle
- und einen Impulsgenerator (16), der zwischen den Ausgang des Rechteckformers und den mit dem Helligkeits- bzw. Farbsteuerungseingang (Z) verbindbaren Ausgangsanschluß (41) geschaltet ist und beim Auftreten der Anstiegs- und/oder Abfallflanken der Rechteckwelle je einen Markierungsimpuls abgibt.

15. Tastkopf nach mindestens einem der Ansprüche 12 bis 14, dadurch gekennzeichnet, daß der Dreiphasen/Zweiphasen-Wandler und der Phasendetektor in einem Tastkopfgehäuse (40) angeordnet sind und mit den Eingangsanschlüssen (37, 38, 39, 44) und den Ausgangsanschlüssen (41, 42, 43) je über ein aus dem Tastkopfgehäuse (40) herausgeführtes Kabel verbunden sind.

16. Tastkopf nach Anspruch 15, dadurch gekennzeichnet, daß die Eingangsanschlüsse und die Ausgangsanschlüsse je einen elektrischen Steckverbinder aufweisen.

17. Tastkopf nach Anspruch 15, dadurch gekennzeichnet, daß die den Eingängen des Dreiphasen/Zweiphasen-Wandlers zugeordneten Kabel je mit einem Stromwandler (37, 38, 39) zur induktiven Verbindung mit der je zugehörigen Stromphase (I1, I2, I3) und von den restlichen Kabeln mindestens die mit dem Oszilloskop verbindbaren Kabel je durch einen Steckverbinder (41, 42, 43) abgeschlossen sind.

18. Tastkopf nach mindestens einem der Ansprüche 12 bis 16, dadurch gekennzeichnet, daß die mit den Eingängen des Dreiphasen/Zweiphasen-Wandlers verbundenen Eingangsanschlüsse zur Verbindung mit den drei Spannungsphasen (U1, U2, U3) eines Dreiphasensystems und der mit dem Phasendetektor verbundene Eingang zur Verbindung mit einer der drei Stromphasen des Dreiphasensystems vorgesehen sind.

19. Tastkopf nach Anspruch 18 in Verbindung mit Anspruch 13, dadurch gekennzeichnet, daß das mit dem Spannungsdetektor verbundene Kabel mit einem Stromwandler (33a) und die restlichen Kabel je mit einem Steckverbinder (33, 35, 36, 36a) abgeschlossen sind.

20. Verfahren zur oszilloskopischen Messung eines Mehrphasensystems mit mehr als drei Phasen, dadurch gekennzeichnet, daß mehrmals eine vektormäßige Summierung entsprechend Anspruch 3 durchgeführt wird, wobei die Resultierende einer vorausgehenden vektormäßigen Summierung mit jeweils einer weiteren der verbliebenen Phasen summiert wird, bis eine Reduktion auf ein Zweiphasensystem erreicht ist.

Figur 1

Figur 2

Figur 3

# Figur 4

Figur 5

Figur 6

Figur7

Figur 8

Figur 9